Europäisches Patentamt

(19) European Patent Office

Office européen des brevets

(11) **EP 0 430 568 B1**

(12) **EUROPEAN PATENT SPECIFICATION**

(45) Date of publication and mention
of the grant of the patent:
**03.09.1997 Bulletin 1997/36**

(51) Int. Cl.$^6$: **C04B 35/00**, H01L 39/12,
H01L 39/24

(21) Application number: **90312677.9**

(22) Date of filing: **21.11.1990**

(54) **Method of making high Tc superconductor material, and article produced by the method**

Verfahren zur Herstellung eines hoch Tc supraleitenden Materials und nach dem Verfahren
hergestellter Artikel

Procédé de fabrication d'un matériau supraconducteur à haute Tc, et article fabriqué par ce procédé

(84) Designated Contracting States:
**DE FR GB**

(30) Priority: **28.11.1989 US 442285**

(43) Date of publication of application:
**05.06.1991 Bulletin 1991/23**

(73) Proprietor: **AT&T Corp.**
**New York, NY 10013-2412 (US)**

(72) Inventors:
• **Jin, Sungho**
**Millington, New Jersey 07946 (US)**
• **Nakahara, Shohei**
**North Plainfield, New Jersey 07060 (US)**
• **Tiefel, Thomas Henry**
**North Plainfield, New Jersey 07060 (US)**

(74) Representative: **Johnston, Kenneth Graham et al**
**Lucent Technologies (UK) Ltd,**
**5 Mornington Road**
**Woodford Green Essex, IG8 OTU (GB)**

(56) References cited:
**EP-A- 0 374 263          US-A- 4 952 390**

• NATURE. vol. 336, 15 December 1988, LONDON
GB pages 660 - 662; J.Karpinski et al.: "Bulk
synthesis of the 81-K superconductor
YBa2Cu4O8 at high oxygen pressure"
• APPLIED PHYSICS LETTERS. vol. 56, no. 13, 26
March 1990, NEW YORK US pages 1287 - 1289;
S.Jin et al.: "Enhanced flux pinning by phase
decomposition in Y-Ba-Cu-O"
• JOURNAL OF SUPERCONDUCTIVITY vol. 2, no.
2, June 1989, Plenum Publishing Corporation
pages 281 - 291; S.Everding et al.: "Preparation
of YBa2Cu3O7-x High-Tc Ceramic
Superconductors from Melt"
• JOURNAL OF THE CERAMIC SOCIETY OF
JAPAN,INTERNATIONAL EDITION vol. 97, no. 10,
October 1989, Fuji Technology Press,Ltd. pages
1014 - 1018; K Sawano et al.: "Effects of
Synthesis Conditions on Microstructure of a
YBa2Cu3Ox Superconductor by Partial Melting
Process"
• APPLIED PHYSICS LETTERS. vol. 52, no. 24, 13
June 1988, NEW YORK US pages 2266 - 2267;
P.N.Peters et al.: "Observation of enhanced
properties in samples of silver oxide doped
YBa2Cu3Ox"

**Description**

**Field of the Invention**

This invention pertains to the field of high temperature superconductors. More particularly, it pertains to methods of making an article that comprises such superconductor material, and to an article produced by the method.

**Background of the Invention**

The discovery of superconductivity in the La-Ba-oxide system (J.G. Bednorz and K.A. Muller, Z. Physik B-Condensed Matter, Vol. 64, pp. 189-193, 1986) precipitated worldwide activity that very soon resulted in the discovery of other classes of oxide superconductors. See, for instance, M.K. Wu et al., Phys. Rev. Letters, Vol. 58(9), pp. 908-910 (1987); R.J. Cava et al., Phys. Rev. Letters, Vol. 58(16), pp. 1676-1679 (1987); D.W. Murphy et al., Phys. Rev. Letters, Vol. 58(16), pp. 1888-1890, 1987; Z.Z. Sheng et al., Nature, Vol. 332, pp. 55-58 1988; H. Maeda et al., Japanese Journal of Applied Physics, Vol. 27(2), pp. L209-L210, 1988; and U.S. patent 4,880,771. J. Karpinski et al., Nature, Vol. 336, p. 660, report synthesis of $YBa_2 Cu_4 O_8$ in 400 bars of $O_2$, and inter alia also disclose that decomposition of $YBa_2 Cu_4 O_8$ at temperatures greater than 900°C leads to $YBa_2 Cu_3 O_{7-s} + CuO$.

Although many of the newly discovered oxide superconductors have transition temperature ($T_c$) above liquid nitrogen temperature (77K) and thus offer promise for widespread technological use, it was soon realized that significant problems have to be overcome before these novel materials can find substantial commercial application. In particular, it was found that bulk samples of the materials typically have a relatively low critical current density ($J_c$). For instance, conventional bulk samples of $YBa_2 Cu_3 O_7$ typically have a $J_c$ of the order of $10^3$ A/cm$^2$ at 77K and in zero applied magnetic field, and still substantially lower in an applied magnetic field. Such a $J_c$ is generally considered to be too low for most applications.

There are at least two problems that contribute to the observed low values of $J_c$ in conventional bulk samples of high $T_c$ (by "high $T_c$" we mean generally $T_c \gtrsim 30K$, preferably > 77K; by "$T_c$" we mean the highest temperature at which the D.C. resistance is zero to within experimental limits) oxide superconductors. (It will be appreciated that bulk samples consist of many superconductor grains or crystallites that are packed to form a relatively dense body). One of the two problems is the so-called "weak link" problem. This pertains to the relatively low value of current that can flow without resistance from one superconductor grain to an adjoining one. This current will be referred to as the "inter-grain" current. The other is the so-called "flux flow" problem. This pertains to the relatively low current that can flow essentially without resistance within a given superconductor grain, due to weak flux pinning. The relevant critical current density will be referred to as the "intra-grain" critical current density and will be designated herein as $J'_c$. It will be appreciated that low values of critical current density are not an inherent property of high $T_c$ oxide superconductors since, for instance, current densities of the order of $10^6$ A/cm$^2$ have been observed in thin films of $YBa_2Cu_3O_7$.

Significant progress towards solution of the weak link problem has already been made. See S. Jin et al., Applied Phys. Letters, Vol. 52(24), pp. 2074-2076, 1988; S. Jin et al., Applied Physics Letters, Vol. 54(6), pp. 584-586, 1989; and Taiwan patent No. 033,357. The progress resulted from the discovery of so-called "melt-textured growth" (MTG), a processing technique that comprises melting and oriented solidification of the superconductor material, resulting in highly textured material that can sustain significantly higher current densities than conventionally prepared bulk material. Bulk samples of $YBa_2Cu_3O_7$, prepared using MTG, have exhibited critical current densities up to about $10^4$ A/cm$^2$ at 77 K in an applied field of 1 Tesla.

Recently progress has also been made in overcoming the flux-flow problem, when it was shown that irradiation of a single crystal of $YBa_2Cu_3O_7$ with fast neutrons can raise $J_c$ of the single crystal to about $6 \times 10^5$ A/cm$^2$ at 77 K and 0.9 Tesla (R. B. van Dover et al., Nature, Vol. 342, pp. 55-57, November 5, 1989). However, neutron irradiation of bulk samples of superconductor would be a relatively costly and inconvenient technique for achieving high $J'_c$ in commercial applications. Thus, the need still exists for finding a method that can be used to produce material with improved intragrain critical current density $J'_c$, i.e., that can result in material with improved flux pinning. This application discloses such a method.

As is well known, the high $T_c$ oxide superconductors that are of relevance to this application are so-called "type II" superconductors. In type II superconductors, for magnetic fields (H) between $H_{c1}$ and $H_{c2}$, magnetic flux lines partially penetrate the superconductor but do not destroy superconductivity ($H_{c1}$ and $H_{c2}$ are the lower and upper critical fields, respectively). It is desirable that the flux lines are strongly "pinned" in the material for $H_{c1} < H < H_{c2}$, since flux line movement results in energy dissipation and electrical resistance. Thus, as is well known, it is necessary to provide strong flux pinning in the material if high $J'_c$ is desired.

In conventional (low $T_c$ type II superconductors) it is known that microscopically fine defects can serve as effective pinning sites, especially if the size scale of the defects is on the order of the superconducting coherence length of the material. However, no technique (other than, possibly, irradiation with fast neutrons) for introducing effective pinning sites into high $T_c$ (oxide) superconductors is known to the art.

As is known to those skilled in the art, intra-grain critical current density in type II superconductors can be estimated by means of the so-called "Bean model" (see C. P. Bean, Reviews of Modern Physics, Vol. 36, p. 31, 1964). The model expresses the intra-grain critical current density $J'_c$ as follows:

$$J'_c = 30 \times \Delta M/d,$$

where $J'_c$ is in A/cm$^2$, $\Delta M$ is the measured magnetization difference (in emu/cm$^3$) between increasing and decreasing applied magnetic field in a magnetization hysteresis measurement, and d is the average grain size in cm. The grain size is typically determined by standard metallographic techniques using optical or scanning electron microscopy.

According to the present invention there is provided a method as defined in claim 1.

In a broad aspect the invention is a method of producing an article that comprises superconductive oxide material of improved properties, including improved intra-grain critical current density, as defined by the claims.

The method comprises forming a multiphase material that comprises as a majority phase a material whose nominal composition differs from that of the desired superconductive oxide material at most with regard to oxygen content, and which further comprises a precipitate phase that is finely dispersed throughout all, or at least a substantial portion, of the majority phase.

More particularly, the inventive method of producing an article comprises providing an appropriate precursor material, heat treating the precursor material such that the multiphase material is formed, and the multiphase material such that the desired superconducting oxide material with the dispersed phase therein results, and optionally carrying out one or more further steps towards completion of the article. It is generally not necessary that all of the precursor material be converted to the desired superconductor and the precipitate phase. Frequently the multiphase material will comprise some left-over precursor material.

The desired superconducting oxide material has nominal composition $M_x M'_y .....O_z$, where M, M', ..... are metal elements, and x, y, ....... z are appropriate positive numbers (not necessarily all integers). Exemplarily, the desired superconductor material has the nominal formula (RE) $Ba_2 Cu_3 O_z$ ($z \sim 7$), where RE is one or more of the rare earths Y, Dy, Gd, Yb, Eu, Nd, Sm, Ho, Er, Tm, La, or Lu. This material will be referred to as "1-2-3" material.

Significantly, the precursor material differs in its stoichiometry from the desired superconducting oxide material at least with regard to a first metal element, which typically is present in the former in greater proportion than in the latter. Furthermore, the precursor material has average composition essentially corresponding to a chemical compound. Exemplarily, the precursor material is (RE) $Ba_2 Cu_4 O_z$, ($z \sim 8$) or (RE) $Ba_2 Cu_{3.5} O_z$ ($z \sim 7.5$). The former will be referred to as "1-2-4" material, and the latter as "1-2-3.5" material.

Heat treating the precursor material is carried out such that the multiphase material is formed from the precursor material, with the precipitate phase comprising the first metal element, and with at least a substantial portion of the precipitate (and/or left-over precursor material) present within crystal grains of the first phase material. Exemplarily, the precipitate is an oxide of the first metal, e.g., CuO or another copper oxide, and the left over precursor is 1-2-3.5 or 1-2-4.

In a currently preferred embodiment of the inventive method the precursor material is selected to have a decomposition temperature $T_d$ lower than the melt temperature ($T_m$) of the majority first phase, and the method comprises maintaining the precursor material at a temperature above $T_d$ (but below $T_m$) for an effective time for forming the dispersed precipitate phase, such that the multiphase material results. Typically, this temperature is at least about 10°C, preferably at least about 30°C, above $T_d$. Typically, the time is in the range 0.1 minutes to 100 hours, preferably 1 minute to 10 hours, depending on the temperature, as will be appreciated by those skilled in the art. The above typical ranges are chosen for the sake of convenience in industrial processing and are not necessarily of fundamental significance.

The preferred embodiment further comprises lowering the temperature of the multiphase material below $T_d$ at an effective rate for retaining at least a substantial portion of the dispersed precipitate phase. Exemplarily, the cooling rate is in the range 5°C/minute-500°C/minute, and the temperature below Td is at most about 800°C. Typically the preferred embodiment also comprises slow cooling (not excluding one or more soaks at an intermediate temperature or temperatures) in an oxygen-containing atmosphere, such that the desired superconductive oxide material results from the majority first phase. It will be understood that in some cases the first phase may have essentially the same oxygen content as the desired superconductive oxide, and thus may be identical with the desired superconductor. This may, for instance, be the case if the desired superconductor does not significantly lose oxygen at the relevant processing temperatures. Exemplary of such superconductors is 1-2-4.

The inventive method can be used to produce bulk high $T_c$ oxide superconductor bodies that have intra-grain critical current density ($J'_c$) substantially higher (typically by at least factors of 2, 5, or even 10) than is attainable in prior art, unirradiated bulk samples of the desired superconductor.

Exemplarily, the precursor material consists essentially of 1-2-4 material (another exemplary precursor compound is 1-2-3.5), the first phase has nominal composition $YBa_2 Cu_3 O_{7-\delta}$, the desired superconducting oxide has nominal composition $YBa_2 Cu_3 O_7$, $T_d$ is about 860°C, the multiphase material is formed at about 900°C, and the multiphase material is cooled to a temperature below $T_d$ at a rate in the approximate range 10-100°C/minute. Exemplary inventive bulk bodies exhibited $J'_c$ of the order of $10^5$ A/cm$^2$ at 77 K in an applied field of 0.9 Tesla, which is more than ten times the value of $J'_c$ observed in a prior art bulk body of YBa$_2$Cu$_3$O$_7$ under the same conditions.

## Brief Description of the Drawings

FIG. 1 shows exemplary data on the temperature dependence of the A.C. magnetic susceptibility of a pellet of 1-2-4 precursor material, and of the same pellet after decomposition and heat treatment in oxygen according to the invention;

FIG. 2 gives exemplary weight loss data for 1-2-4 and for 1-2-3 material;

FIG. 3 shows exemplary magnetization data for material produced according to the invention and for conventionally produced 1-2-3 material; and

FIGS. 4-6 depict exemplary potential applications for high $T_c$ superconductor bodies produced according to the invention.

## Detailed Description of Some Preferred Embodiments

The invention is expected to be broadly applicable to oxide superconductors. Practice of the invention requires substantially only the existence of an appropriate precursor compound that can be caused to decompose (at a temperature that is lower than the decomposition temperature and/or melting temperature of the majority first phase material) into a multiphase material that comprises first phase material and, finely dispersed therein, a precipitate phase, with the first phase material being the desired superconductor, or being transformable into the desired superconductor by an appropriate heat treatment. However, for the sake of definiteness and ease of exposition, the discussion below will be primarily in terms applicable to 1-2-3 material as the desired oxide superconductor. In the most commonly used 1-2-3 material RE is Y. Since other 1-2-3 materials are known to behave very similarly to YBa$_2$Cu$_3$O$_z$ ($z \sim 7$), results obtained with YBa$_2$Cu$_3$O$_z$ generally can be directly applied to any other 1-2-3 material.

An important aspect of the inventive method is the choice of precursor material. The precursor material may or may not be a superconductor. For instance, 1-2-4 material and 1-2-3.5 material can both be superconductive, with $T_c$ of 70-80K and about 50K. respectively. However, if insufficiently oxidized 1-2-4 and 1-2-3.5 material can have lower $T_c$ or be non-superconducting, while still being useful as precursor material. Furthermore, in principle precursor material that is not a superconductor at all can also be useful in the practice of the invention. It will be appreciated that a superconductor such as 1-2-4 (especially Ca-substituted 1-2-4) potentially can be the desired superconductor, as well as being a possible precursor for 1-2-3 material.

Typically, the precursor material consists essentially of a stoichiometric (except possibly with regard to oxygen) chemical compound (or compounds) that decomposes above the decomposition temperature $T_d$ into the multiphase material. The latter comprises the majority first phase which has a composition which differs from that of the desired superconductor at most with regard to oxygen content. The multiphase material further comprises a finely dispersed precipitate phase.

As will be evident to those skilled in the art, both the first phase and the precipitate phase are required to be substantially stable over some temperature range above $T_d$. It will also be evident that many of the general temperatures referred to herein are not exactly defined (in the sense a melting temperature of a compound is defined) but instead are kinetically determined. For instance, $T_d$ herein is a temperature at which decomposition of the precursor compound occurs at an industrially acceptable rate, e.g., such that about 90% of the precursor decomposes in less than 24 hours.

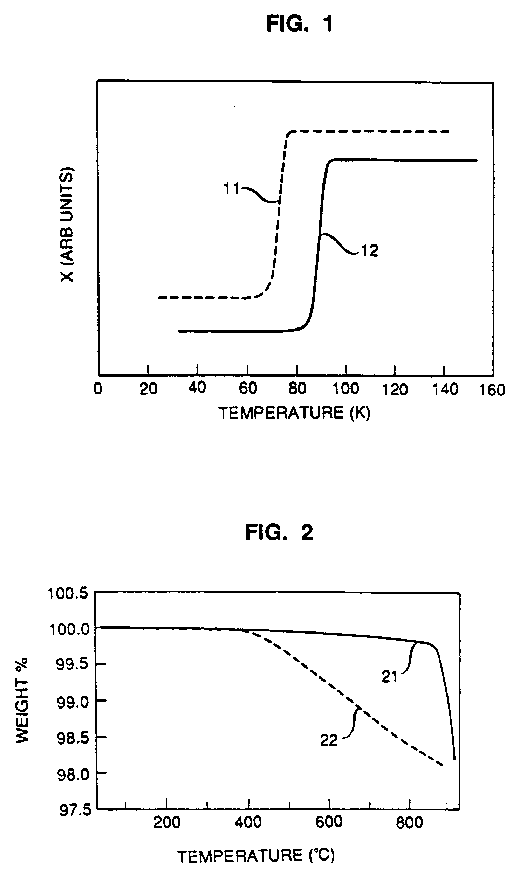

If the desired superconductor has nominal composition YBa$_2$Cu$_3$O$_7$ then YBa$_2$Cu$_4$O$_z$ ($z \sim 8$) is an advantageous exemplary precursor. As is known, the 1-2-4 phase can be viewed as containing in each unit cell of the lattice an additional CuO layer, as compared to the 1-2-3 phase, and has a $T_c$ of about 70-80K. Whereas it has been previously disclosed (see D. E. Morris et al., Physica C, Vol. 159, pp. 287-294, 1989) that the synthesis of 1-2-4 requires relatively high oxygen pressure (e.g., about 3.5 MPa (35 atm.)), we have found that high quality 1-2-4 bodies can be synthesized even at an oxygen pressure of $10^5$ Pa (1 atm). Exemplarily this is accomplished by mixing an appropriate amount of CuO (or CuO dissolved in acid) with 1-2-3 powder, grinding the mixture, forming a body, sintering it at about 810°C (with intermediate grinding and pressing) for a total time of about 12 days in oxygen. FIG. 1 shows (curve 11) A.C. magnetic susceptibility data of thus prepared YBa$_2$Cu$_4$O$_8$, and FIG. 2 shows thermogravimetric weight loss data (curve 21) for such YBa$_2$Cu$_4$O$_8$. The latter shows decomposition of 1-2-4 material at temperatures above about 850°C. FIGS. 1 and 2 also show the corresponding data for YBa$_2$Cu$_3$O$_z$ ($z \sim 7$) produced by decomposition of YBa$_2$Cu$_4$O$_8$ according to the invention (curves 12 and 22, respectively).

(RE) Ba$_2$Cu$_4$O$_z$ is not the only precursor compound that can be used to produce 1-2-3-type superconductors according to the invention. (RE) Ba$_2$Cu$_{3.5}$O$_z$ is another useful precursor compound. Others will likely be found, as the relevant phase diagram is being established. Furthermore, other compounds will be useful in the production of high $T_c$ materials other than (RE) Ba$_2$Cu$_3$O$_z$.

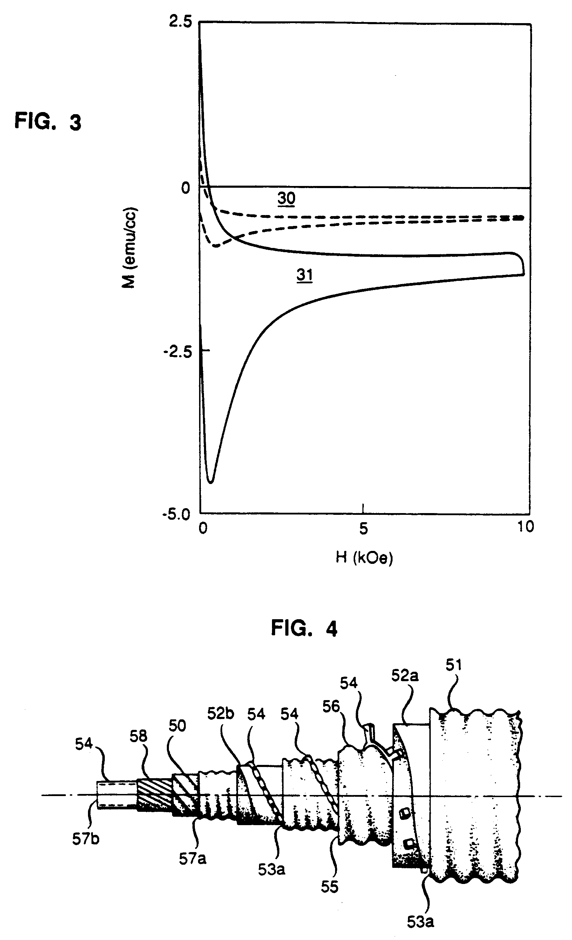

FIG. 3 shows conventional magnetization data for material produced according to the invention (curve 31), and for

conventionally produced $YBa_2Cu_3O_7$ (curve 30), with the desired superconductor in the inventive material also being $YBa_2Cu_3O_7$. Both curves show magnetic hysteresis, but the amount of hysteresis (expressible as the absolute difference in magnetization between the lower (increasing H) and upper (decreasing H) branches of the magnetization curve; this difference is designated $\Delta M$) is substantially larger in curve 31. This translates into substantially larger $J'_c$ in the inventive material, assuming that both materials have similar grain sizes (this similarity was in fact observed).

It is expected that material according to the invention can be used in essentially all applications in which prior art (high and low $T_c$) bulk superconductors have been used, or have been proposed for use.

For a general overview of some potential applications of superconductors see, for instance, B. B. Schwartz and S. Foner, editors, Superconductor Applications: SQUIDs and Machines, Plenum Press 1977; and S. Foner and B. B. Schwartz, editors, Superconductor Material Science, Metallurgy, Fabrications, and Applications, Plenum Press 1981. Among the applications are power transmission lines, rotating machinery, and superconductive magnets, for e.g., fusion generators, MHD generators, particle accelerators, levitated vehicles, magnetic separation, and energy storage, as well as junction devices and detectors

By "bulk" superconductors we mean herein not only relatively massive bodies and elongate bodies such as wires, tape or sheet (including metal-clad or metal core superconductive wire, tape or sheet) but also "thick" films of the type produced by silk screening or similar processes. The inventive method may also be usefully applied to thin films produced by such deposition techniques as sputtering, vapor deposition, or laser ablation, where it can further enhance flux pinning.

Bulk superconductor bodies according to the invention may comprise, in addition to the desired superconductor material and the dispersed precipitate phase (and possibly left over precursor material), other material (or materials) that is compatible with the inventive process and does not substantially poison the superconductor. Exemplary of such materials are Ag and silver oxide in the form of particles. As is known, the presence of silver particles can advantageously affect the mechanical and thermal properties of 1-2-3 material, can improve oxygen diffusion into the body, and can result in reduced contact resistance. See, for instance, S. Jin et al., Applied Physics Letters, Vol. 54, page 2605, (1989).

Furthermore, other phases of the relevant material system that can coexist with the desired superconductor may be present. Exemplarily, in the Y-BaCu-oxide system such phases may be $Y_2BaCuO_5$, $Y_2O_3$, $BaCuO_5$. No material is present in an amount greater than the desired superconductor, and typically the desired superconductor is at least 50% by volume of the material according to the invention.

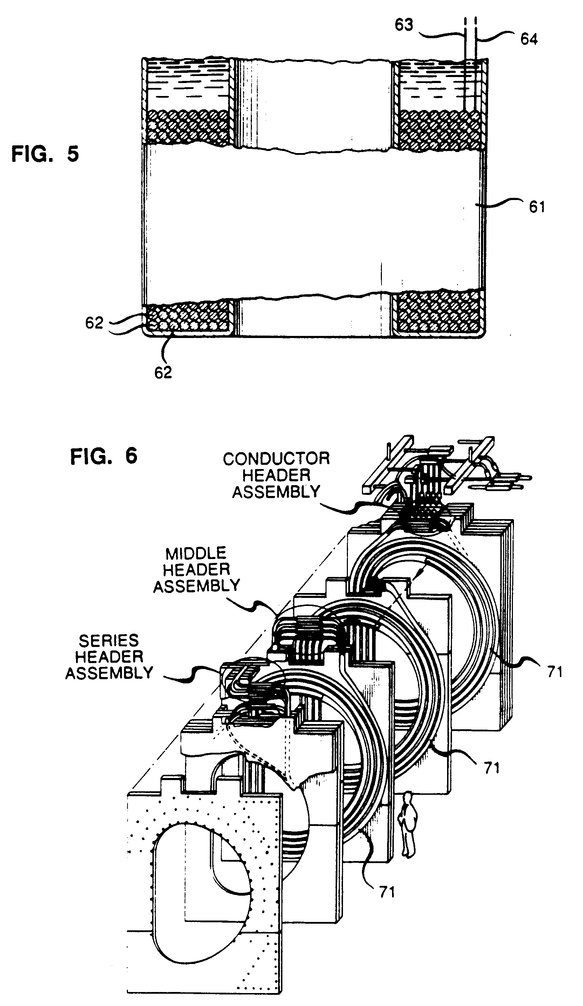

FIGS. 4-6 illustrate potential applications of superconductors according to the invention. The structure shown in FIG. 4 is described in detail in G. Bogner, "Large Scale Applications of Superconductivity", in Superconductor Applications: SQUIDs and Machines, B. B. Schwartz, and S. Foner, editors, (Plenum Press, New York, 1977). Briefly, the structure depicted consists of an outer sheathing 51, thermal insulation layers 52a and 52b, evacuated annular regions 53a and 53b, spacers 54, nitrogen-filled annular region 55, heat shield 56, and coolant regions 57a and 57b. Element 58 is a superconductor material in accordance with the invention. FIG. 5 shows a superconducting magnet comprising an annular cryostat 61 filled with an appropriate cryogenic liquid and containing turns 62 of a superconductive material according to the invention. Terminal leads 63 and 64 are shown emerging from the coil. The structure of FIG. 5 is described in R. A. Hein and D. U. Gubser, "Applications in the United States", in Superconductor Materials Science: Metallurgy, Fabrication, and Applications, S. Foner and B. B. Schwartz, editors, (Plenum Press, New York, 1981). The superconducting elements shown in FIG. 6 as windings 71 are made of a material herein. The structure of FIG. 6 is considered exemplary of those expected to find broad-scale use for containment of fusion reactions.

Example 1: A quantity of previously prepared $YBa_2Cu_3O_7$ powder was mixed with sufficient CuO powder to result in a mixture of average composition corresponding to $YBa_2Cu_4O_x$. After further grinding, the mixture was pressed into pellets (2 x 3 x 30 mm), and the pellets heated in air to 810°C. These conditions were maintained, with several intermediate grinding and pelletizing steps, for a total of 12 days. A subsequent powder X-ray analysis of one pellet showed the material to be essentially pure 1-2-4 phase. The material had a $T_c$ of about 75K. Several of the thus produced pellets were heated to 810°C, maintained at that temperature for 15 minutes, heated in 5 minutes to 920°C, held at that temperature for 1.5 minutes, followed by rapid cooling (total cooling time 10 minutes) to 750°C, all in flowing oxygen. The treatment resulted in substantially complete decomposition of the 1-2-4 precursor into multicomponent material (containing 1-2-3 material and finely dispersed copper oxide), with at least a major portion of the dispersed copper oxide retained during the rapid cool-down. After the rapid cool-down to 750°C the pellets were slowly cooled in flowing oxygen to below 380°C at 25°C/hour to adjust the oxygen stoichiometry of the 1-2-3 material. Transmission electron microscopy revealed the presence of many fine copper oxide particles, (typically 100-400 nm in diameter) and a high density of defects in the 1-2-3 phase surrounding the particles.

AC magnetization measurements showed that the thus produced multiphase material had $T_c$ of about 90K, and X-ray diffraction analysis showed the presence of essentially only $YBa_2Cu_3O_7$ peaks and CuO peaks. Magnetization measurements at 77K resulted in the data presented as curve 31 of FIG. 3. A conventional $YBa_2Cu_3O_7$ pellet (produced from the same batch of 1-2-3 powder used in the above referred-to mixture, sintered at 920°C for 8 hours, cooled at 25°C/hour to below 380°C, all in flowing oxygen) was also measured, with the results shown as curve 30 in FIG. 3.

The average grain size of both materials was determined by a conventional metallographic technique. Some of the results are given in Table I, wherein "A" refers to the prior art comparison sample, and "B" to the material according to the invention, 1 emu/cm$^3$ = 4$\pi$ x 10$^3$ A/m.

Table I

| | $\Delta$M at H=0.9Tesla (emu/cm$^3$) | d (cm) | J$'_c$ at H=0.9 Tesla (A/cm$^2$) |
|---|---|---|---|
| A | 0.04 | 1.5 x 10$^{-4}$ | 0.8 x 10$^4$ |
| B | 0.35 | 1.0 x 10$^{-4}$ | 1.1 x 10$^5$ |

Example 2: A pellet of multiphase superconductive material (first phase YBa$_2$Cu$_3$O$_x$) was produced substantially as described in Example 1 except that the pellet was held at 920°C for 4 hours. The resulting material had $\Delta$M = 5.78 x 10$^3$ A/m (0.46 emu/cm$^3$), d ~1.7 x 10$^{-4}$cm, and J$'_c$ ~ 7.7 x 10$^4$ A/cm$^2$ at 77K, H = 0.9 Tesla.

Comparative Example 3: A pellet was produced substantially as described in Example 2, except that the time at 920°C was 16 hours. The resulting material had $\Delta$M = 1.63 x 10$^3$ A/m (0.13 emu/cm$^3$), d ~ 4.3 x 10$^{-4}$ cm, and J$'_c$ ~ 0.9 x 10$^4$ A/cm$^2$ at 0.9 Tesla.

Examples 2 and 3 illustrate the importance of decomposition time, with long decomposition times resulting in lower J$'_c$. Typically, optimal decomposition time is a function of the temperature. For temperatures relatively close to T$_d$ it is expected that optimal decomposition times will be relatively long, whereas the times are expected to be relatively short for temperatures relatively far above T$_d$. Whereas the melting temperature T$_m$ of the lowest-melting phase of the multiphase material is certainly an upper limit on the temperature for decomposition, in some material systems one or more of the phases of the multiphase material may decompose at a temperature below T$_m$. In such systems the temperature for decomposition of the precursor material may be selected to be below any decomposition temperature associated with the multiphase material. If the desired superconductor is a 1-2-3 type material, then decomposition typically is carried out above about 860°C, preferably above about 900°C, for a time in the range 0.1 minutes to 10 hours, still more preferably 1 minute to 4 hours. Too short time and/or too low temperature can result in insufficient decomposition of precursor material, whereas too long time and/or too high temperature result in undesirable annealing out or coarsening of the flux pinning defects.

As demonstrated by Example 1, material produced according to the invention can have J$'_c$ that is substantially higher (more than an order of magnitude) than that observed in conventional high T$_c$ material of analogous composition. This improvement is attributed to enhanced flux pinning in the inventive material. The exact nature of the pinning centers is not yet fully understood. Possible pinning centers include finely dispersed CuO (or other copper oxide) precipitates, or defects associated with the precipitates, or with the formation of the precipitates, or with the decomposition process, or with left-over precursor material.

In a further exemplary embodiment the precursor material is preliminarily subjected to a MTG process (possibly at relatively high oxygen pressure) such that the precursor material has a dense, highly oriented structure, whereby the detrimental effect of weak links can be reduced. Grain orientation of precursor material can also be achieved by other means, e.g., by mechanical or magnetic field alignment, or by epitaxial growth on a substrate from a solution, melt, or vapor phase, and all such means are contemplated.

## Claims

1.  Method of making an article that comprises a material comprising polycrystalline superconducting oxide of nominal composition (RE) Ba$_2$Cu$_3$O$_x$, with RE selected from the group consisting of Y, Dy, Gd, Yb, Eu, Nd, Ho, Er, Tm, La, Lu, and combinations thereof, and with x ~ 7; the method comprising

    a) providing a quantity of precursor material selected from the group consisting of oxides of nominal composition (RE) Ba$_2$Cu$_{3.5}$O$_y$ and (RE) Ba$_2$Cu$_4$O$_z$, with y and z being approximately 7.5 and 8, respectively;
    b) keeping said precursor material in an oxygen-containing atmosphere at a temperature T for a time t, where T is greater than 900°C and a precursor material decomposition temperature T$_d$, and is less than a melting temperature T$_m$ of the superconducting oxide, and where T and t are furthermore selected such that a multiphase material is formed from the precursor material, said multiphase material comprising as a majority phase a polycrystalline first material of nominal composition (RE) Ba$_2$Cu$_3$O$_{x'}$, with x' < x, and further comprising a Cu-containing second phase;
    c) cooling said multiphase material to a temperature below T$_d$ at a rate effective for retaining at least a substantial portion of said second phase; and

d) keeping said multiphase material in an oxygen-containing atmosphere at a temperature or temperatures and for a time effective for transformation of at least some of said polycrystalline first material into said polycrystalline superconducting oxide, with said polycrystalline superconducting oxide being at least 50% by volume of the material;

CHARACTERIZED IN THAT

e) t is in the range 1 minute to 4 hours;

f) just prior to said cooling step, at least a substantial portion of said Cu-containing second phase is in the form of precipitate particles that are dispersed within crystallites of the polycrystalline first material;

g) said cooling is at a rate effective for retaining at least a substantial portion of said dispersed precipitate particles, and said time and temperature or temperatures of step d) are also effective for retaining at least a substantial portion of the dispersed precipitate particles, whereby said superconducting oxide material can have a relatively high value of an intra-granular critical current $J'_c$.

## Patentansprüche

1. Verfahren zur Herstellung eines Gegenstands, der ein Material mit polykristallinem supraleitenden Oxid der Nennzusammensetzung $(RE)Ba_2Cu_3O_x$ umfaßt, wobei RE ausgewählt ist aus der Gruppe, die aus Y, Dy, Gd, Yb, Eu, Nd, Ho, Er, Tm, La, Lu und deren Kombinationen besteht, und wobei x ~ 7 ist, wobei das Verfahren umfaßt:

a) Bereitstellen einer Menge eines Vorläufermaterials, das ausgewählt ist aus der Gruppe, die aus Oxiden mit der Nennzusammensetzung $(RE)Ba_2Cu_{3,5}O_y$ und $(RE)Ba_2Cu_4O_z$ besteht, wobei y und z ungefähr 7,5 bzw. 8 sind,

b) Halten des Vorläufermaterials in einer sauerstoffenthaltenden Atmosphäre bei einer Temperatur T während einer Zeit t, wobei T größer als 900°C und eine Vorläufermaterialzersetzungstemperatur $T_d$ ist und niedriger ist als eine Schmelztemperatur $T_m$ des supraleitenden Oxids, und wobei T und t weiter derart ausgewählt sind, daß ein Mehrphasenmaterial als Majoritätsphase ein erstes polykristallines Material der Nennzusammensetzung $(RE)Ba_2Cu_3O_{x'}$ mit x' < x umfaßt und ferner eine Cu-enthaltende zweite Phase umfaßt,

c) Abkühlen des Mehrphasenmaterials bei einer Geschwindigkeit, die wirksam ist, um wenigstens einen wesentlichen Anteil der zweiten Phase zurückzubehalten, auf eine Temperatur unterhalb von $T_d$ und

d) Halten des Mehrphasenmaterials in einer sauerstoffenthaltenden Atmosphäre bei einer Temperatur oder Temperaturen und während einer Zeit, die wirksam sind, um wenigstens etwas des polykristallinen ersten Materials in das polykristalline supraleitende Oxid umzuwandeln, wobei das polykristalline supraleitende Oxid wenigstens 50 Volumenprozent des Materials beträgt, dadurch gekennzeichnet, daß

e) t in dem Bereich von 1 Minute bis 4 Stunden liegt,

f) gerade nach dem Schritt des Abkühlens wenigstens ein wesentlicher Teil der Cu-enthaltenden zweiten Phase in der Form von Präzipitatpartikeln, die innerhalb der Kristallite des ersten polykristallinen Materials dispergiert sind, vorliegt,

g) wobei das Abkühlen bei einer Geschwindigkeit stattfindet, die wirksam ist, um wenigstens einen wesentlichen Anteil der dispergierten Präzipitatpartikel zurückzubehalten und wobei die Zeit und die Temperatur oder Temperaturen des Schrittes d) ebenfalls wirksam sind, um wenigstens einen wesentlichen Anteil der dispergierten Präzipitatpartikel zurückzubehalten, wobei das supraleitende Oxidmaterial einen relativ hohen Wert eines intragranulären kritischen Stroms $J'_c$ haben kann.

## Revendications

1. Procédé de fabrication d'un article qui comprend un matériau comprenant un oxyde supraconducteur polycristallin ayant comme composition nominale $(RE)Ba_2Cu_3O_x$, où RE est choisi dans l'ensemble constitué de Y, Dy, Gd, Yb, Eu, Nd, Ho, Er, Tm, La, Lu et leurs combinaisons, x valant environ 7 ; le procédé consistant

a) à fournir une certaine quantité d'un matériau précurseur choisi dans le groupe constitué des oxydes ayant pour composition nominale $(RE)Ba_2Cu_{3,5}O_y$ et $(RE)Ba_2Cu_4O_z$, y et z valant approximativement et respectivement 7,5 et 8 ;

b) à maintenir ledit matériau précurseur dans une atmosphère contenant de l'oxygène à une température T pendant un temps t, où T est supérieur à 900°C et à une température $T_d$ de décomposition du matériau précurseur, et est inférieur à une température de fusion $T_m$ de l'oxyde supraconducteur, et où T et t sont en outre sélectionnés de façon qu'un matériau multiphasique soit formé à partir du matériau précurseur, ledit matériau multiphasique comprenant en tant que phase majoritaire un premier matériau polycristallin ayant pour composition nominale $(RE)Ba_2Cu_3O_{x'}$, avec x'<x, et comprenant en outre une deuxième phase contenant du Cu ;

c) à refroidir ledit matériau multiphasique à une température inférieure à $T_d$, à une vitesse de refroidissement suffisante pour retenir au moins une partie notable de ladite deuxième phase ; et

d) à maintenir ledit matériau multiphasique dans une atmosphère contenant de l'oxygène à une température ou à des températures et pendant un laps de temps suffisants pour permettre une transformation d'au moins une partie dudit premier matériau polycristallin en ledit oxyde supraconducteur polycristallin, ledit oxyde supraconducteur polycristallin représentant au moins 50 % en volume du matériau ;

　　caractérisé en ce que

e) $t$ est compris entre 1 minute et 4 heures ;

f) juste avant ladite étape de refroidissement, au moins une partie notable de ladite deuxième phase contenant du Cu se présente sous la forme de particules précipitées qui sont dispersées à l'intérieur de cristallites du premier matériau polycristallin ;

g) ledit refroidissement s'effectue à une vitesse suffisante pour retenir au moins une partie notable desdites particules précipitées en dispersion, et le temps et la ou les températures de l'étape d) sont également suffisants pour retenir au moins une partie notable desdites particules précipitées en dispersion, le matériau d'oxyde supraconducteur pouvant avoir une valeur relativement grande du courant $J'_c$ critique intragranulaire.

# FIG. 1

# FIG. 2

FIG. 3

FIG. 4

FIG. 5

FIG. 6

CONDUCTOR
HEADER
ASSEMBLY

MIDDLE
HEADER
ASSEMBLY

SERIES
HEADER
ASSEMBLY